# EUROPÄISCHE PATENTSCHRIFT

(11) **EP 1 806 039 B1**
(45) Veröffentlichungstag und Bekanntmachung des Hinweises auf die Patenterteilung: **05.05.2010**
(21) Anmeldenummer: 05799045.9
(22) Anmeldetag: 28.09.2005
(51) Int. Cl.: H05K 5/02

(54) **BELÜFTUNGSEINRICHTUNG ZUR ERMÖGLICHUNG DES GASAUSTAUSCHS DURCH EINE WANDUNG EINES GEHÄUSES**
VENTILATION DEVICE FOR ENABLING A GAS TRANSFER VIA A WALL OF A HOUSING
DISPOSITIF D'AÉRATION PERMETTANT L'ÉCHANGE GAZEUX À TRAVERS UNE PAROI DE BOÎTIER

(30) Priorität: 28.10.2004 DE 102004052361
(43) Veröffentlichungstag der Anmeldung: 11.07.2007
(73) Patentinhaber: Schreiner Group GmbH & Co. KG, 85764 Oberschleissheim (DE)
(72) Erfinder: WOLFF, Thomas, 85716 Unterschleissheim (DE)
(74) Vertreter: Epping - Hermann - Fischer
(86) Internationale Anmeldenummer: PCT/EP2005/054871
(87) Internationale Veröffentlichungsnummer: WO 2006/045685

(56) Entgegenhaltungen:
- EP-A2- 0 862 354
- WO-A-99/29150
- DE-A1- 19 653 890
- GB-A- 2 330 952

## Beschreibung

Die vorliegende Erfindung betrifft eine Belüftungseinrichtung zur Ermöglichung des Gasaustauschs durch eine Wandung eines Gehäuses, insbesondere eine Belüftungseinrichtung zur Ermöglichung des Gasaustauschs durch eine Wandung eines Gehäuses, aufweisend eine in der Wandung angeordnete Vertiefung, eine Innenöffnung, welche die Vertiefung mit der Innenseite des Gehäuses verbindet, und eine Abdeckung, welche die Vertiefung zur Außenseite des Gehäuses hin teilflächig abdeckt, so daß mindestens eine zur senkrechten Projektion der Innenöffnung auf die Abdeckung überdeckungsfrei versetzte Außenöffnung freibleibt, welche die Vertiefung mit der Außenseite des Gehäuses verbindet.

Elektrische und elektronische Geräte werden, beispielsweise im Automobilbau oder bei verfahrenstechnischen Apparaten und Maschinen, häufig in staubiger, feuchter oder korrosiver Umgebung eingesetzt. Zudem können sie mitunter mechanischen Belastungen, etwa Schlag- oder Stoßbelastungen ausgesetzt sein. Um die Funktion der enthaltenen elektrischen bzw. elektronischen Bauteile sicherzustellen, werden die Geräte daher in geschlossene Gehäuse eingebaut. Letztere müssen zwar gegen die genannten schädigenden Einflüsse abgedichtet sein, dennoch ist es in aller Regel erforderlich, Druckausgleichsöffnungen vorzusehen, die einen Gasaustausch mit der Umgebung zulassen. Insbesondere muß bei sinkender Umgebungstemperatur gewährleistet sein, daß Wassermoleküle aus der im Gehäuseinneren enthaltenen Luft nach außen diffundieren können, um schädliche Kondensation im Gerät zu vermeiden. Die Luft im Gehäuseinneren so trocken zu halten, daß bei allen erwartbaren Umgebungstemperaturen keine Kondensation auftritt, scheitert zumeist daran, daß eine völlig hermetische Gehäuseabdichtung ebenso wie die Entfeuchtung der Umgebungsluft bei der Gehäusebestückung vor Verschließen des Gehäuses unverhältnismäßig teuer wäre, oder aber, daß das Gehäuse während seines Gebrauchszyklus mehrmals geöffnet wird. Letzteres ist zum Beispiel bei einem Lampengehäuse der Fall, welches eine vielfach höhere Betriebsdauer besitzt, als das darin eingesetzte Leuchtmittel.

Um dennoch das Eindringen von flüssigem Wasser und Staub zu vermeiden, werden dem Druckausgleich bzw. Dampfdruckausgleich dienende Gasaustauschöffnungen zuweilen mit gasdurchlässigen Membranen verschlossen. Entsprechende Membranen können auch als selbstklebende Etiketten oder Teile davon vorgesehen werden, um eine einfache Anbringung zu ermöglichen. Ein derartiges Etikett ist beispielsweise aus der deutschen Offenlegungsschrift DE 196 53 890 A1 bekannt.

Häufig ist es jedoch nicht ausreichend, eine Gasaustauschöffnung lediglich mit einer Membran abzudecken, denn übliche Membranen bieten nur begrenzten Schutz gegen das Hindurchtreten von Flüssigkeiten. So tritt beispielsweise durch die meisten handelsüblichen Membranen Wasser hindurch, wenn der Strahl eines Hochdruckreinigers darauf gerichtet ist. Dies ist in der Praxis, beispielsweise bei Steuergeräten von Baumaschinen oder elektronischen Einrichtungen in der Verfahrenstechnik nicht ungewöhnlich.

Ferner können freiliegende Membranen durch mechanische Beschädigungen undicht oder gar völlig zerstört werden.

Aus WO 99/29150 A1 ist bekannt, eine mit einer Membran überklebte Gasaustauschöffnung in einer Vertiefung einer Gehäusewand anzubringen und die Vertiefung mit einer schützenden Abdeckung, welche zugleich auch als Typenschild fungieren kann, zu überkleben. Der Gasaustausch bleibt gewährleistet, indem ausgehend von der Vertiefung kanalartige Ausnehmungen (Belüftungskanäle) in der Gehäusewand vorgesehen sind, welche von der Abdeckung nur teilweise bedeckt werden, wodurch eine Belüftungseinrichtung der eingangs genannten Art entsteht. Eine derartige Anordnung ist jedoch recht aufwendig in der Herstellung, da die relativ kompliziert geformten Ausnehmungen durch entsprechend komplexe Formgebungs- bzw. Bearbeitungsprozesse in der Gehäusewand erzeugt werden. Ferner kann bereits ein nicht allzu großer, durch fehlerhafte Anbringung verursachter lateraler Versatz der Abdeckung gegenüber ihrer vorgesehenen Position dazu führen, daß die Belüftungskanäle vollständig abgedeckt sind, und die Belüftungsvorrichtung nicht mehr funtioniert. Ferner muß die Abdeckung spezifisch für die zu überdeckende Geometrie gefertigt sein, um die Funktion zu gewährleisten.

Angesichts der oben geschilderten Problematik liegt der vorliegenden Erfindung die Aufgabe zugrunde, eine Belüftungseinrichtung der eingangs genannten Art zu schaffen, welche einfacher und zu geringeren Kosten herstellbar ist, und dabei eine höhere Funktionssicherheit aufweist. Ferner ist es Aufgabe der Erfindung, ein Verfahren zur Herstellung von Belüftungseinrichtungen in Gehäusewandungen verschiedener Gehäusechargen zu schaffen, welches schnelle und auch unvorhergesehene Chargenwechsel erlaubt.

Gemäß einem Aspekt der vorliegenden Erfindung wird die zugrundeliegende Aufgabe durch eine Belüftungseinrichtung nach Anspruch 1 gelöst.

Vorteilhafte Ausführungsformen der erfindungsgemäßen Belüftungseinrichtung können gemäß einem der Ansprüche 2-14 gestaltet sein.

Die aufwendige Fertigung komplizierter Kanalstrukturen in der Gehäusewandung ist erfindungsgemäß nicht mehr erforderlich. Vielmehr können auch einfache Geometrien der Vertiefung (kreisförmig, oval, polygonartig etc.) ohne Einbußen bei der Funktionsfähigkeit umgesetzt werden. Die Anbringung der Abdeckung gestattet größere Toleranzen hinsichtlich lateraler Verschiebungen als beim Stand der Technik.

Während es in manchen Fällen ausreichend sein kann, die Innenöffnung nicht eigens mit einer gaspermeablen Membran zu überdecken, ist diese Maßnahme meist zur Vermeidung des Eindringens von Fremdstoffen angezeigt. Für eine entsprechende Überdeckung der Innenöffnung kommen eine Vielzahl an sich bekannter Membranen, beispielsweise aus expandiertem PTFE, in Frage. Ferner können auch Mikrofasergewebe und dergleichen verwendet werden. Die Membran kann aufgeklebt oder auch anderweitig befestigt sein.

Die Abdeckung der Vertiefung kann aus unterschiedlichsten Materialien bestehen, besonders bevorzugt sind jedoch ein- oder mehrlagige Folien. Verwendung finden können hier insbesondere übliche Kunststoffolien, beispielsweise aus PET, PE, PP, PVC usf. Je nach zu erwartender mechanischer Beanspruchung können auch Gewebelagen oder Nonwovens in die Folie integriert sein. Gasdurchlässige Gewebelagen oder Nonwovens können im Bereich der Außenöffnung(en) auch durchgängig (d.h. die Außenöfnung verdeckend) ausgeführt sein und so das Eindringen von Fremdkörpern, beispielsweise Sandkörnern in die Vertiefung vermeiden. Ferner können die Außenöffnungen auch durch eine in den Folienaufbau integrierte gaspermeable Membranlage abgedeckt sein, um einen zweistufigen Schutz gegen das Eindringen von Flüssigkeiten ins Gehäuseinnere zu bieten. In Hinblick auf den Schutz gegen eindringende Fremdkörper kann es auch besonders vorteilhaft sein, eine Vielzahl kleiner Außenöffnungen anstatt einer oder weniger größerer Außenöffnungen vorzusehen. Die Möglichkeit einer derartigen Erhöhung des Schutzes des Gehäuseinnern gegen das Eindringen von Fremdstoffen ist bei herkömmlichen Belüftungseinrichtungen der eingangs genannten Art nicht möglich.

Je nach Anwendungsbereich kann es auch vorteilhaft sein, die Abdeckung aus anderen Materialien, beispielsweise dünnem Blech, herzustellen.

Neben der besonders bevorzugten Anbringung durch Aufkleben kann die Abdeckung je nach Materielpaarung Gehäuse/Abdeckung und je nach Anwendungsbereich auch auf andere Weise vorteilhaft befestigt sein, beispielsweise durch Vulkanisieren, Schweißen, Löten, Schrauben oder Klemmen. Das Aufkleben läßt sich besonders gut umsetzen, wenn die Abdeckung vor dem Anbringen unterseitig mit Klebstoff beschichtet ist. Möglich sind hier sowohl eine vollflächige Klebstoffbeschichtung, als auch eine Klebstoffbeschichtung lediglich in den Randbereichen der Abdeckung. Grundsätzlich eignet sich eine große Bandbreite an üblichen Klebstoffen, woraus in Abhängigkeit des konkreten Anwendungsfalls auszuwählen ist. Neben üblichen Haftklebstoffen können hitzeaktivierbare Klebstoffe (sogenannte Hotmelts) und mittels UV-Licht oder Feuchteexposition aushärtende Klebstoffe vorteilhaft sein.

Sind mehrere Außenöffnungen in der Abdeckung vorgesehen, so können diese derart positioniert werden, daß Flüssigkeit nach Eintritt in die Vertiefung aus dieser bei unterschiedlicher Raumorientierung des Gehäuses wieder abfließen kann. Hierfür sind die Außenöffnungen in unterschiedlichen Richtungen (von der senkrechten Projektion der Innenöffnung auf die Abdeckung aus betrachtet) seitlich versetzt zur Innenöffnung anzuordnen.

Wenn die senkrechte Projektion der Randlinie der Vertiefung auf die Abdeckung die Randlinie zumindest einer der Außenöffnungen schneidet oder berührt, kann Flüssigkeit aus der Vertiefung besonders gut abfließen. Berührt oder schneidet die senkrechte Projektion der Randlinie der Vertiefung auf die Abdeckung die Randlinie zumindest einer der Außenöffnungen nicht, so ergeben sich hierdurch meist geringere Anforderung an die Genauigkeit der Positionierung der Abdeckung bei deren Anbringung.

In der Abdeckung können auch Öffnungen vorgesehen sein, welche außerhalb der senkrechten Projektion der Randlinie der Vertiefung auf die Abdeckung liegen, also direkt auf der Gehäusewandung aufliegen. Derartige Öffnungen erfüllen zwar keine Funktion, dadurch lassen sich jedoch vielseitig einsetzbare Standardabdeckungen verwenden, welche auch bei anderer Anordnung der abzudeckenden Vertiefung ihre Funktion erfüllen. Durch höhere Stückzahlen bei der Produktion der Abdeckungen ist somit eine Kostensenkung möglich.

Gemäß einem weiteren Aspekt der vorliegenden Erfindung wird die dieser zugrundeliegende Aufgabe durch ein Verfahren nach Anspruch 15 gelöst.

Vorteilhafte Ausführungsformen des erfindungsgemäßen Verfahrens können gemäß einem der Ansprüche 16-22 gestaltet sein.

Die Erfindung bietet die Möglichkeit, standardisiertes Flachmaterial für die Abdeckungen zu verwenden, welches dann chargenspezifisch, vorzugsweise "in line", mit Außenöffnungen versehen wird. Erfindungsgemäße Belüftungseinrichtungen sind so flexibel und mit geringen Material- und Vorhaltungskosten auch bei einer größeren Anzahl unterschiedlich gestalteter Gehäusetypen mit häufigem und/oder unvorhergesehenem Chargenwechsel möglich.

Grundsätzlich kann jede im Rahmen der vorliegenden Anmeldung beschriebene bzw. angedeutete Variante der Erfindung besonders vorteilhaft sein, je nach wirtschaftlichen und technischen Bedingungen im Einzelfall. Soweit nichts gegenteiliges dargelegt ist, bzw. soweit grundsätzlich technisch realisierbar, sind einzelne Merkmale der beschriebenen Ausführungsformen austauschbar oder miteinander kombinierbar.

Nachfolgend werden anhand der zugehörigen Zeichnungen Beispiele bevorzugter Ausführungsformen der vorliegenden Erfindung näher erläutert. Die Zeichnungen sind dabei rein schematische und nicht maßstäbliche Darstellungen. Einander entsprechende Elemente sind in den einzelnen Figuren jeweils, soweit sinnvoll, mit denselben Bezugszeichen versehen.
- Fig. 1a: zeigt in perspektivischer Schrägansicht die auch als Typenschild fungierende Abdeckung einer erfindungsgemäßen Belüftungseinrichtung mit zwei Außenöffnungen. Der Rand der Vertiefung und die senkrechte Projektion der Innenöffnung auf die Abdeckung sind strichliert angedeutet.
- Fig. 1b: zeigt in perspektivischer Schrägansicht einen Auschnitt einer Gehäusewandung mit einer zur selben Belüftunseinrichtung wie Fig. 1a gehörenden Vertiefung, in welcher die Innenöffnung mittels einer aufgeklebten Membran überdeckt ist. Die Position der zugehörigen Abdeckung aus Fig. 1a ist strichliert angedeutet.
- Fig. 1c: zeigt in perspektivischer Schrägansicht den Auschnitt der Gehäusewandung aus Fig. 1b, jedoch ohne die Membran. Die Position der Abdeckung aus Fig. 1a sowie der Außenöffnungen sind strichliert angedeutet.
- Fig. 1d: zeigt in perspektivischer Schrägansicht einen Schnitt durch die Gehäusewandung aus Fig. 1b mit darauf angebrachter Abdeckung aus Fig. 1a, wobei Abdeckung, Membran und Gehäusewandung jeweils entlang verschiedener Schnittlinien geschnitten sind.
- Fig. 1e: zeigt die Abdeckung aus Fig. 1a in der Draufsicht, wobei der Rand der Vertiefung und die senkrechte Projektion der Innenöffnung auf die Abdeckung strichliert angedeutet sind.
- Fig. 2a: zeigt in der Draufsicht eine Belüftungseinrichtung mit einer ähnlich Fig. 1e gestalteten Abdeckung über einer strichliert angedeuteten Vertiefung mit Innenöffnung, wobei die Gehäuseumrisse rechteckförmig angedeutet sind.
- Fig. 2b: zeigt eine Belüftungseinrichtung, bei welcher im Unterschied zu Fig. 2a sich die strichliert angedeutete Vertiefung mit Innenöffnung in einer anderen Position relativ zum Anbringungsort der Abdeckung befindet.
- Fig. 3a: zeigt in der Draufsicht eine weitere Belüftungseinrichtung mit strichliert angedeuteter Vertiefung und Innenöffnung.
- Fig. 3b: zeigt eine ähnlich Fig. 3a gestaltete Belüftungseinrichtung mit einer Abdeckung, welche aus einem gleichen Rohling gefertigt ist wie die Abdeckung in Fig. 3a, wobei jedoch die Außenöffnung aufgrund unterschiedlicher Position von strichliert angedeuteter Vertiefung und Innenöffnung gegenüber Fig. 3a an anderer Stelle angeordnet ist.
- Fig. 3c: zeigt eine ähnliche Fig. 3a gestaltete Belüftungseinrichtung, wobei im Unterschied zu Fig. 3b eine Vielzahl kleiner Außenöffnungen anstelle einer größeren Außenöffnung vorgesehen ist.

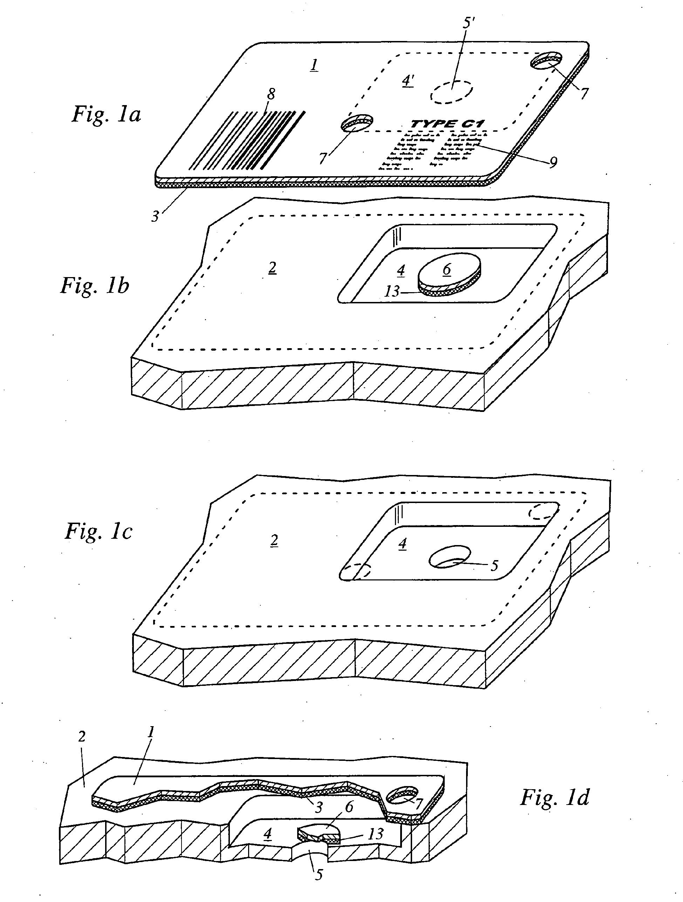

Figuren 1a-e illustrieren dieselbe Auführungsform. Die Abdeckung 1 ist über eine unterseitige selbstklebende Beschichtung 3 auf der Gehäusewandung 2 angebracht und deckt die darin vorgesehene Vertiefung 4 ab. In der Vertiefung 4 ist eine zum Gehäuseinneren durchgehende Innenöffnung 5 vorgesehen. Die senkrechte Projektion der Vertiefung 4 und der Innenöffnung 5 auf die Abdeckung 3 wird nachfolgend mit den Bezugszeichen 4' bzw. 5' bezeichnet. Über die Innenöffnung 5 ist eine gasdurchlässige jedoch flüssigkeitsundurchlässige Membran 6 geklebt. Die unterseitige Klebstoffbeschichtung 13 ist im Bereich der Innenöffnung 5 unterbrochen, um nicht die Poren der Membran 6 zu verschließen.

Die zwei Außenöffnungen 7 sind seitlich versetzt zur Projektion 5' der Innenöffnung 5 und in unterschiedlichen Richtungen von dieser angeordnet. Die Anordnung der Außenöffnungen 7 in zwei gegenüberliegenden "Ecken" der der Rechteckform angenäherten Vertiefung 4 ist in Hinblick auf das Ablaufen von Flüssigkeit aus der Vertiefung 4 besonders günstig. Stellt man sich drei aufeinander senkrecht stehende Drehachsen vor, um welche die Gehäusewandung 2 drehbar ist, so ergibt sich für jede der Achsen ein Drehbereich von jeweils 180°, innerhalb welchem Flüssigkeit aus der Vertiefung 4 durch eine der Außenöffnungen 7 ablaufen kann. Dies bedeutet, daß bei einem Viertel aller möglichen Orientierungen, welche die Gehäusewandung 2 im Raum einnehmen kann, auch Flüssigkeit unter Schwerkrafteinwirkung aus der Vertiefung 4 abfließt, sollte sie in diese gelangt sein. Durch weitere Außenöffnungen 7 in den verbleibenden beiden Ecken könnte Flüssigkeit bei der Hälfte aller möglichen Orientierungen, welche die Gehäusewandung 2 im Raum einnehmen kann, unter Schwerkrafteinwirkung aus der Vertiefung 4 abfließen. Gleiches würde für die Anordnung dreier Außenöffnungen 7 in den Ecken einer der Dreiecksform angenäherten Vertiefung 4 gelten. Weiter verbessern läßt sich das Abfließverhalten, wenn die Wandungen der Vertiefung 4 schräg gestaltet werden, so daß sich die Vertiefung 4 nach außen hin erweitert, bzw. wenn die Vertiefung 4 muldenförmig ausgeführt ist.

Die Anordnung der Außenöffnungen 7 in der Abdeckung gemäß Fig. 1a-e bedingt auch, daß zumindest eine Außenöffnung 7 selbst dann freibleibt, wenn die Abdeckung 1 in der Herstellung der Belüftungseinreichtung versehentlich mit starkem seitlichen Versatz angebracht wird.

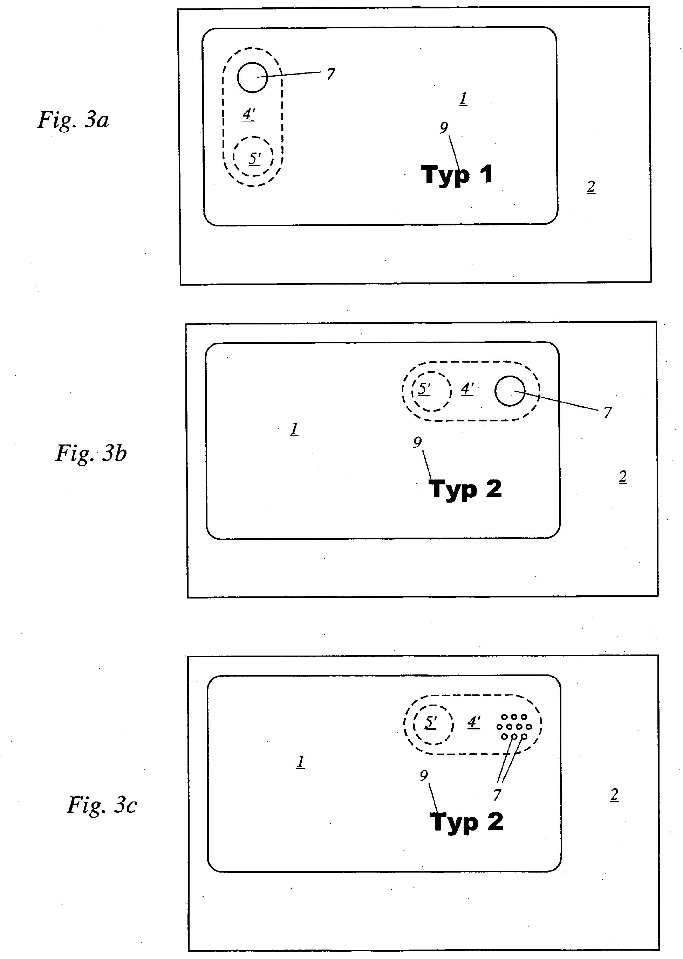

Ebenfalls möglich und erfindungsgemäß ist eine Anordnung der Abdecköffnungen 7, bei welcher der Rand der Abdecköffnungen 7 den Rand der senkrechten Projektion 4' der Vertiefung 4 auf die Abdeckung 1 weder berührt noch schneidet (wie unten im Zusammenhang mit Figuren 3a-c) beschrieben).

Die Abdeckung 1 ist durch Bedrucken oder Laserbeschriften mit einem Barcode 8 und einer alphanumerischen Aufschrift 9 um auch als Typenschild fungieren zu können. Selbstverständlich ist auch eine Gestaltung als Warn- oder Hinweisschild, dekorative Blende oder ähnliches möglich.

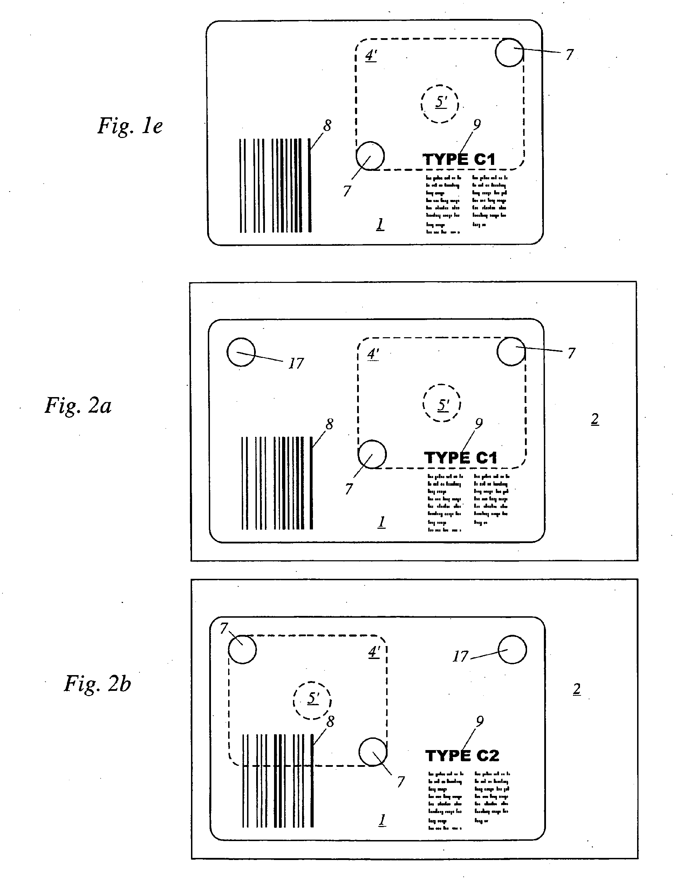

Wie durch Vergleich mit Fig. 1e leicht zu erkennen, sind die Belüftungseinrichtungen in Figuren 2a-b ähnlich gestaltet. Die Abdeckung 1 weist jedoch jeweils eine weitere Öffnung 17 auf, welche außerhalb der Vertiefung 4 (erkennbar an deren senkrechter Projektion 4' auf die Abdeckung 1) liegt und somit direkt auf der Gehäusewandung 2 aufliegt. Diese Öffnung 17 besitzt im Einsatz keine Funktion, jedoch lassen sich hierdurch gleichgestaltete Abdeckungen für die in Fig. 2a und Fig. 2b dargestellten Varianten verwenden, obwohl die Vertiefung 4 und Innenöffnung 5 (erkennbar an deren senkrechten Projektionen 4' bzw. 5 'auf die Abdeckung 1) in den beiden Varianten unterschiedlich angeordnet sind. Dies ermöglicht eine die Produktion der zwei unterschiedlichen Gehäusetypen verbilligende Gleichteilestrategie in der Fertigung.

Auch Figuren 3a-c zeigen Gehäusewandungen 2, bei welchen die Vertiefung 4 und Innenöffnung 5 (erkennbar an deren senkrechten Projektionen 4' bzw. 5' auf die Abdeckung 1) an zwei verschiedenen Positionen angeordnet sind. Erfindungsgemäß läßt sich ein jeweils gleichgestalteter Rohling für die jeweilige Abdeckung 1 verwenden. Die chargenspezifische bzw. gehäusespezifische Beschriftung 9 sowie die Außenöffnung 7 bzw. Außenöffnungen 7 werden kurz vor (ggf. auch kurz nach) Anbringung der Abdeckung 1, vorzugsweise "in line", passend zum jeweiligen Gehäusetyp erzeugt. Zum Einbringen der Außenöffnungen 7 können dabei beispielsweise Stanzwerkzeuge oder ein Laser verwendet werden. Möglich sind auch Varianten von Abdeckungsrohlingen, welche an verschiedenen Stellen bereits vorgeschwächt sind, um an den Schwächungsstellen je nach Bedarf Außenöffnungen zu erzeugen.

Bei der in Fig. 3c dargestellten Variante sind gegenüber der in Fig. 3b dargestellten Variante eine Vielzahl kleiner Außenöffnungen 7 statt einer größeren Außenöffnung 7 vorgesehen. Diese Ausführungsform erschwert das Eindringen von Fremdkörpern, beispielsweise Sandkörnern, in die Vertiefung 4.

Erfindungsgemäß lassen sich bei Bedarf auch mehrere Vertiefungen 4 mit jeweiligen Innenöffnungen 5 durch eine gemeinsame Abdeckung 1 abdecken.

## Patentansprüche

1. Belüftungseinrichtung zur Ermöglichung des Gasaustauschs durch eine Wandung (2) eines Gehäuses, aufweisend
eine in der Wandung (2) angeordnete Vertiefung (4),
eine Innenöffnung (5), welche die Vertiefung (4) mit der Innenseite des Gehäuses verbindet,
eine Abdeckung (1), welche die Vertiefung (4) zur Außenseite des Gehäuses hin teilflächig abdeckt, so daß mindestens eine zur senkrechten Projektion (5') der Innenöffnung (5) auf die Abdeckung (1) überdeckungsfrei versetzte Außenöffnung (7) freibleibt, welche die Vertiefung (4) mit der Außenseite des Gehäuses verbindet,
**dadurch gekennzeichnet, daß** die Außenöffnung (7) in der Abdeckung (1) ausgebildet und von dieser vollständig umgrenzt ist.

2. Belüftungseinrichtung gemäß Anspruch 1, wobei unterhalb der Abdeckung (1) eine die Innenöffnung (5) verschließende gaspermeable Membran (6) angeordnet ist.

3. Belüftungseinrichtung gemäß Anspruch 2, wobei die Membran (6) zumindest teilweise hydrophob oder hydrophobisiert ist.

4. Belüftungseinrichtung gemäß einem der Ansprüche 2-3, wobei die Membran (6) zumindest teilweise oliophob oder oliophobisiert ist.

5. Belüftungseinrichtung gemäß einem der vorangehenden Ansprüche, wobei in der Abdeckung (1) mindestens zwei Außenöffnungen (7) ausgebildet sind.

6. Belüftungseinrichtung gemäß Anspruch 5, wobei zumindest zwei der Außenöffnungen (7) in unterschiedlichen Richtungen zur senkrechten Projektion (5') der Innenöffnung (5) auf die Abdeckung (4) versetzt sind.

7. Belüftungseinrichtung gemäß Anspruch 6, wobei die Verbindungslinien zwischen den Mittelpunkten zweier der Außenöffnungen (7) und dem Mittelpunkt der senkrechten Projektion (5') der Innenöffnung (5) auf die Abdeckung (1) einen Winkel von mindestens 90 Grad einschließen.

8. Belüftungseinrichtung gemäß einem der vorangehenden Ansprüche, wobei die senkrechte Projektion (4') der Randlinie der Vertiefung (4) auf die Abdeckung (1) die Randlinie zumindest einer der Außenöffnungen (7) schneidet oder berührt.

9. Belüftungseinrichtung gemäß einem der vorangehenden Ansprüche, wobei die senkrechte Projektion (4') der Randlinie der Vertiefung (4) auf die Abdeckung (1) die Randlinie zumindest einer der Außenöffnungen (7) weder schneidet noch berührt.

10. Belüftungseinrichtung gemäß einem der vorangehenden Ansprüche, wobei in der Abdeckung (1) Öffnungen (17) vorgesehen sind, welche außerhalb der senkrechten Projektion (4') der Randlinie der Vertiefung (4) auf die Abdeckung (1) liegen.

11. Belüftungseinrichtung gemäß einem der vorangehenden Ansprüche, wobei die Abdeckung (1) auf die Wandung (2) aufgeklebt ist.

12. Belüftungseinrichtung gemäß einem der vorangehenden Ansprüche, wobei die Abdeckung (1) mit Text- und/oder Bild- und/oder Code-Information (8, 9) versehen ist.

13. Belüftungsvorrichtung gemäß Anspruch 12, wobei zumindest ein Teil der Text- und/oder Bild- und/oder Code-Information (8, 9) aufgedruckt ist.

14. Belüftungseinrichtung gemäß einem der Ansprüche 12-13, wobei zumindest ein Teil der Text- und/oder Bild- und/oder Code-Information (8, 9) durch ein Laserbeschriftungsverfahren erzeugt ist.

15. Verfahren zur Herstellung von Belüftungseinrichtungen zur Ermöglichung des Gasaustauschs durch Wandungen (2) von Gehäusen, wobei
- mehrere Chargen von Gehäusen, aufweisend eine Wandung (2) mit für jede Charge einheitlicher, von Charge zu Charge unterschiedlicher Vertiefungsanordnung mit mindestens einer Vertiefung (4) und mindestens einer Innenöffnung (5), welche die Vertiefung (4) mit der Innenseite des Gehäuses verbindet, bereitgestellt werden,
- eine mindestens der Zahl der Gehäuse entsprechende Zahl an Abdeckungen (1) einander gleicher Abmessungen, welche die Abmessungen der größten Vertiefung (4) übersteigen, bereitgestellt wird,
- die Vertiefungsanordnung jedes Gehäuses durch Anbringen einer Abdeckung (1) an einer für jede Charge einheitlichen Position des jeweiligen Gehäuses abgedeckt wird, und
- die Abdeckungen (1) an für jede Charge von Gehäusen einheitlichen, von Charge zu Charge unterschiedlichen Positionen der jeweiligen Abdeckung (1) mit mindestens einem Loch (7) versehen werden, welches nach Anbringen der Abdeckung (1) überdeckungsfrei versetzt ist zur senkrechten Projektion (5') der Innenöffnung (5) der abgedeckten Vertiefungsanordnung auf die Abdeckung (1).

16. Verfahren gemäß Anspruch 15, wobei die Abdeckungen (1) durch Lasereinwirkung mit dem mindestens einen Loch (7) versehen werden.

17. Verfahren gemäß Anspruch 15, wobei die Abdeckungen (1) durch Stanzen mit dem mindestens einen Loch (7) versehen werden.

18. Verfahren gemäß einem der Ansprüche 15-17, wobei das Anbringen der Abdeckungen (1) durch Kleben erfolgt.

19. Verfahren gemäß einem der Ansprüche 15-18, wobei die Abdeckungen (1) mit von Charge zu Charge unterschiedlicher Text- und/oder Bild- und/oder Code-Information (8, 9) versehen werden.

20. Verfahren gemäß Anspruch 19, wobei zumindest ein Teil der Text- und/oder Bild- und/oder Code-Information (8, 9) aufgedruckt wird.

21. Verfahren gemäß einem der Ansprüche 19-20, wobei zumindest ein Teil der Text- und/oder Bild- und/oder Code-Information (8, 9) durch einen Laserbeschriftungsprozeß erzeugt wird.

## Claims

1. A ventilation device for enabling gas exchange through a wall (2) of a housing, comprising
a recess (4) disposed in the wall (2),
an inner opening (5) connecting the recess (4) to the inner side of the housing,
a cover (1) partially covering the recess (4) toward the outer side of the housing, so that at least one outer opening (7) offset to the perpendicular projection (5') of the inner opening (5) remains open without overlapping onto the cover (1) connecting the recess (4) to the outer side of the housing,
**characterized in that** the outer opening (7) is formed in the cover (1) and is completely encompassed by said cover.

2. The ventilation device according to claim 1, wherein a gaspermeable membrane (6) closing off the inner opening (5) is disposed below the cover (1).

3. The ventilation device according to claim 2, wherein the membrane (6) is at least partially hydrophobic or hydrophobized.

4. The ventilation device according to any one of the claims 2-3, wherein the membrane (6) is at least partially oleophobic or oleophobized.

5. The ventilation device according to any one of the preceding claims, wherein at least two outer openings (7) are formed in the cover (1).

6. The ventilation device according to claim 5, wherein at least two of the outer openings (7) are offset in different directions to the perpendicular projection (5') of the inner opening (5) onto the cover (4).

7. The ventilation device according to claim 6, wherein the connecting lines between the center points of two of the outer openings (7) and the center point of the perpendicular projection (5') of the inner opening (5) onto the cover (1) enclose an angle of at least 90 degrees.

8. The ventilation device according to any one of the preceding claims, wherein the perpendicular projection (4') of the edge line of the recess (4) onto the cover (1) intersects or contacts the edge line of at least one of the outer openings (7) .

9. The ventilation device according to any one of the preceding claims, wherein the perpendicular projection (4') of the edge line of the recess (4) onto the cover (1) neither intersects nor contacts the edge line of at least one of the outer openings (7).

10. The ventilation device according to any one of the preceding claims, wherein openings (17) are provided in the cover (1), said openings being located outside of the perpendicular projection (4') of the edge line of the recess (4) on the cover (1).

11. The ventilation device according to any one of the preceding claims, wherein the cover (1) is glued to the wall (2).

12. The ventilation device according to any one of the preceding claims, wherein the cover (1) has text and/or image and/or code information (8, 9).

13. The ventilation device according to claim 12, wherein at least a part of the text and/or image and/or code information (8, 9) is imprinted.

14. The ventilation device according to any one of claims 12-13, wherein at least part of the text and/or image and/or code information (8,9) is generated by a laser inscribing process.

15. A method for producing ventilation devices for enabling gas exchange through walls of housing, wherein
- a plurality of batches of housings is provided, comprising a wall (2) having a recess arrangement that is uniform for each batch and different from batch to batch, and that has at least one recess (4) and at least one inner opening (5) connecting the recess (4) to the inner side of the housing,
- a number of covers (1) are provided at least corresponding to the number of housings and having dimensions identical to each other, wherein the dimensions exceed the largest recess (4),
- the recess arrangement of each housing is covered by applying a cover (1) at a position that is uniform for each batch, and
- the covers (1) are provided with at least one hole (7) at a position that is uniform for each batch of housings, but is different from batch to batch for each of the covers (1), said hole being offset to the perpendicular projection (5') of the inner opening (5) of the covered recess arrangement onto the cover (1) without overlap after attaching the cover (1).

16. The method according to claim 15, wherein the covers (1) are provided with the at least one hole (7) by laser action.

17. The method according to claim 15, wherein the covers (1) are provided with the at least one hole (7) by punching.

18. The method according to any one of claims 15-17, wherein the covers (1) are attached by gluing.

19. The method according to any one of claims 15-18, wherein the covers (1) are provided with text and/or image and/or code information (8, 9) that is different from batch to batch.

20. The method according to claim 19, wherein at least a part of the text and/or image and/or code information (8, 9) is imprinted.

21. The method according to any one of claims 19-20, wherein at least part of the text and/or image and /or code information (8, 9) is generated by a laser inscribing process.

## Revendications

1. Dispositif d'aération pour permettre l'échange de gaz à travers une paroi (2) d'un boîtier, comportant un creux (4) disposé dans la paroi (2),
une ouverture intérieure (5), laquelle relie le creux (4) avec le côté intérieur du boîtier,
un revêtement (1), lequel recouvre le creux (4) sur une partie de sa surface vers le côté extérieur du boîtier, de telle manière qu'une ouverture extérieure (7) au moins reste libre et décalée sans chevauchement par rapport à la projection verticale (5') de l'ouverture intérieure (5) sur le revêtement (1), laquelle relie le creux (4) avec le côté extérieur du boîtier.
**caractérisé en ce que** l'ouverture extérieure (7) est formée dans le revêtement (1) et qu'elle est entièrement circonscrite par ce dernier.

2. Dispositif d'aération selon la revendication 1, sachant qu'une membrane (6) perméable aux gaz et obstruant l'ouverture intérieure (5) est disposée sous le revêtement (1) .

3. Dispositif d'aération selon la revendication 2, sachant que la membrane (6) est au moins partiellement hydrophobe ou rendue hydrophobe.

4. Dispositif d'aération selon l'une quelconque des revendications 2-3, sachant que la membrane (6) est au moins partiellement oliophobe ou rendue oliophobe.

5. Dispositif d'aération selon l'une quelconque des revendications précédentes, sachant que deux ouvertures extérieures (7) au moins sont formées dans le revêtement (1).

6. Dispositif d'aération selon la revendication 5, sachant que deux au moins des ouvertures extérieures (7) sont décalées dans des directions différentes par rapport à la projection verticale (5') de l'ouverture intérieure (5) sur le revêtement.

7. Dispositif d'aération selon la revendication 6, sachant que les lignes de jonction entre les centres de deux des ouvertures extérieures (7) et le centre de la projection verticale (5') de l'ouverture intérieure sur le revêtement (1) circonscrivent un angle de 90 degrés au moins.

8. Dispositif d'aération selon l'une quelconque des revendications précédentes, sachant que la projection verticale (4') de la ligne marginale du creux (4) sur le revêtement (1) est en intersection ou en contact avec la ligne marginale de l'une au moins des ouvertures extérieures (7).

9. Dispositif d'aération selon l'une quelconque des revendications précédentes, sachant que la projection verticale (4') de la ligne marginale du creux (4) sur le revêtement (1) n'est ni en intersection, ni en contact avec la ligne marginale de l'une au moins des ouvertures extérieures (7).

10. Dispositif d'aération selon l'une quelconque des revendications précédentes, sachant que des ouvertures (17) sont prévues dans le revêtement (1), lesquelles sont situées hors de la projection verticale (4') de la ligne marginale du creux (4) sur le revêtement (1).

11. Dispositif d'aération selon l'une quelconque des revendications précédentes, sachant que le revêtement (1) est collé sur la paroi (2).

12. Dispositif d'aération selon l'une quelconque des revendications précédentes, sachant que le revêtement (1) est doté d'une information sous forme de texte et/ou d'image et/ou de code (8, 9).

13. Dispositif d'aération selon la revendication 12, sachant qu'une partie au moins de l'information sous forme de texte et/ou d'image et/ou de code (8, 9) est imprimée.

14. Dispositif d'aération selon l'une quelconque des revendications 12-13, sachant qu'une partie au moins de l'information sous forme de texte et/ou d'image et/ou de code (8, 9) est générée à l'aide d'un procédé d'écriture laser.

15. Procédé pour la fabrication de dispositifs d'aération pour permettre l'échange de gaz à travers des parois (2) de boîtiers, sachant
- que plusieurs lots de boîtiers sont fournis, comportant une paroi (2) avec un arrangement de creux identique pour chaque lot et différent de lot à lot, avec au moins un creux (4) et au moins une ouverture intérieure (5), laquelle relie le creux (4) avec le côté intérieur du boîtier,
- qu'il est fourni un nombre de revêtements (1) au moins équivalent au nombre de boîtiers, lesdits revêtements (1) étant de dimensions identiques, supérieures aux dimensions du plus grand creux (4),
- que l'arrangement de creux de chaque boîtier est recouvert par pose, sur chacun des boîtiers, d'un revêtement (1) à une position identique pour chaque lot, et
- que les revêtements (1) sont dotés d'au moins un trou (7) à une position de chaque revêtement (1) identique dans chaque lot de boîtiers et différente de lot à lot, lequel trou (7) est décalé sans chevauchement par rapport à la projection verticale (5') de l'ouverture intérieure (5) de l'arrangement de creux recouvert sur le revêtement (1).

16. Procédé selon la revendication 15, sachant que les revêtements (1) sont dotés de l'au moins un trou (7) par l'action d'un laser.

17. Procédé selon la revendication 15, sachant que les revêtements (1) sont dotés de l'au moins un trou (7) par poinçonnage.

18. Procédé selon l'une quelconque des revendications 15-17, sachant que la pose des revêtements (1) s'effectue par collage.

19. Procédé selon l'une quelconque des revendications 15-18, sachant que les revêtements (1) sont dotés d'une information sous forme de texte et/ou d'image et/ou de code (8, 9) différente de lot à lot.

20. Procédé selon la revendication 19, sachant qu'une partie au moins de l'information sous forme de texte et/ou d'image et/ou de code (8, 9) est imprimée.

21. Procédé selon l'une quelconque des revendications 19-20, sachant qu'une partie au moins de l'information sous forme de texte et/ou d'image et/ou de code (8, 9) est générée à l'aide d'un procédé d'écriture laser.
